(19) **Europäisches Patentamt**
**European Patent Office**
**Office européen des brevets**

(11) **EP 1 836 770 B1**

(12) **EUROPÄISCHE PATENTSCHRIFT**

(45) Veröffentlichungstag und Bekanntmachung des Hinweises auf die Patenterteilung:
**11.02.2009 Patentblatt 2009/07**

(21) Anmeldenummer: **05825233.9**

(22) Anmeldetag: **21.12.2005**

(51) Int Cl.:
***H03K 19/18*** *(2006.01)*   ***G11C 11/18*** *(2006.01)*

(86) Internationale Anmeldenummer:
**PCT/EP2005/057054**

(87) Internationale Veröffentlichungsnummer:
**WO 2006/074859 (20.07.2006 Gazette 2006/29)**

(54) **NICHTFLÜCHTIG REKONFIGURIERBARE DIGITALE LOGIKEINHEIT**

NON-VOLATILE RECONFIGURABLE DIGITAL LOGIC UNIT

UNITE LOGIQUE NUMERIQUE A RECONFIGURATION NON VOLATILE

(84) Benannte Vertragsstaaten:
**DE FR GB**

(30) Priorität: **14.01.2005 DE 102005001938**

(43) Veröffentlichungstag der Anmeldung:
**26.09.2007 Patentblatt 2007/39**

(73) Patentinhaber: **SIEMENS AKTIENGESELLSCHAFT**
**80333 München (DE)**

(72) Erfinder: **BANGERT, Joachim**
**91052 Erlangen (DE)**

(56) Entgegenhaltungen:
**WO-A-20/04051853    DE-C1- 10 053 206**
**DE-C1- 10 144 395**

- **RICHTER R ET AL: "Nonvolatile field programmable spin-logic for reconfigurable computing" APPLIED PHYSICS LETTERS, AIP, AMERICAN INSTITUTE OF PHYSICS, MELVILLE, NY, US, Bd. 80, Nr. 7, 18. Februar 2002 (2002-02-18), Seiten 1291-1293, XP012031618 ISSN: 0003-6951**

**EP 1 836 770 B1**

**Beschreibung**

Die Erfindung betrifft eine nichtflüchtig rekonfigurierbare digitale Logikeinheit mit ein magnetisches Schichtsystem aufweisenden Zellen, deren Widerstand durch Magnetfeldpulse veränderbar ist, umfassend einen ersten Leitungszweig mit in Reihe geschalteten Datenzellen und einen zweiten Leitungszweig mit in Reihe geschalteten konfigurierbaren Konfigurierzellen und ein Auswertemittel für die konfigurierten Zustände.

Diese Zellen ermöglichen die Speicherung von Informationen auf magnetischer Basis. Die Magnetisierung einer Schicht des magnetischen Schichtsystems der Zelle kann durch einen Magnetfeldpuls geändert werden, wodurch sich der Magnetowiderstand dieser Schicht um einige Prozent ändert. Der jeweilige Widerstand kann ausgelesen werden und ist ein Maß für den logischen Zustand der Zelle.

Es ist bereits vorgeschlagen worden, programmierbare Logikfunktionen mit Zellen zu realisieren, die von dem GMR-Effekt Gebrauch machen. Derartige Logikschaltungen können ähnlich wie herkömmliche programmierbare Logikfelder aufgebaut werden und verwenden magnetoresistive Zellen als nichtflüchtige programmierbare Elemente oder als Felder, die aus Logikgattern bestehen, wobei die Logikfunktionen durch magnetische Logik programmiert werden können. Diese logischen Schaltungen weisen den Vorteil auf, dass sowohl die Programminformationen als auch die Daten nichtflüchtig sind. Daher besteht die Möglichkeit, ein ganzes Logikfeld nach Bedarf in eine bestimmte Konfiguration umzuprogrammieren.

In dem Artikel "Programmable logic using giant-magnetoresistance and spin-dependent tunneling devices" (Black und Das, Journal of Applied Physics, Vol. 87, No. 9, 01.05.2000) ist eine magnetische vergleicherlogik vorgeschlagen worden, bestehend aus einem ersten Leitungszweig mit in Reihe geschalteten Datenzellen und einem zweiten parallelen Datenzweig mit in Reihe geschalteten Konfigurationszellen. Die möglichen Zustände werden ausgewertet, indem konfigurierte magnetische Zellinhalte mit Datenzellen verglichen werden. Beide Zweige, das heißt die Datenzellen und die Konfigurationszellen, werden von einem vorgegebenen Konstantstrom durchflossen und die durch die jeweiligen Zellen entstehenden Spannungsabfälle werden den Eingängen eines Vergleichers zugeführt. Durch die magnetische Konfiguration der einzelnen Zellen, die entweder einen hohen oder einen niedrigen Widerstand besitzen, ergibt sich ein stufenförmiger Signalverlauf. Beim niedrigsten Spannungswert sind alle Widerstände niederohmig, ist einer hochohmig und alle anderen niederohmig, ergibt sich die nächste Stufe. Um die konfigurierten Zustände auswerten zu können, ist ein Vergleicher erforderlich, der die Differenzspannung der beiden parallelen Zweige ermittelt. In dem Vergleicher kann geprüft werden, ob eine bestimmte Bedingung erfüllt ist, die Bedingung kann beispielsweise lauten: "Widerstand des Zweiges der Datenzellen kleiner oder gleich dem Widerstand des Zweiges der Konfigurationszellen". Die Festlegung der Schaltschwellen ist allerdings schwierig, da eine Reihe von Parametern die Eigenschaften der magnetischen Zellen beeinflusst. Dazu zählen beispielsweise die Ungleichheit von Stromquellen in den beiden Zweigen, durch Lithografie verursachte Schwankungen, Abweichungen der Zuleitungswiderstände, ein eventuell vorhandenes asymmetrisches Verhalten des Vergleichers und weitere Effekte.

Der Erfindung liegt daher das Problem zugrunde, eine nichtflüchtig rekonfigurierbare digitale Logikeinheit mit einem Auswertemittel für die konfigurierten Zustände zu schaffen, das eine sichere Entscheidung ermöglicht.

Zur Lösung dieses Problems ist eine nichtflüchtig rekonfigurierbare digitale Logikeinheit mit den Merkmalen des Anspruchs 1 vorgesehen.

Erfindungsgemäß umfasst das Auswertemittel der Logikeinheit einen Differenzverstärker zum Ermitteln eines die Differenzspannung der Leitungszweige angebenden Spannungssignals. Jede der magnetischen Zellen bewirkt einen Spannungsabfall, die Ausgänge der beiden Leitungszweige werden den Eingängen des Differenzverstärkers zugeführt, der die Differenzspannung der beiden Eingangsspannungen bildet und dieses Spannungssignal gegebenenfalls verstärkt. Daneben ist erfindungsgemäß ein vorzugsweise als Addierer oder Subtrahierer ausgebildetes Mittel vorgesehen, um das von dem Differenzverstärker ermittelte Spannungssignal auf einen von 0 Volt verschiedenen Wert zu verschieben. Ein derart verschobenes Signal kann anschließend besonders leicht von einem Komparator oder Fensterkomparator ausgewertet werden, der entscheidet, ob das Spannungssignal in einem gültigen oder in einem verbotenen Bereich liegt. Diese Schaltungsgruppe ist vorteilhaft ein Subtrahierer oder ein Addierer. Daneben umfasst die erfindungsgemäße Logikeinheit ein Mittel zum Bewerten eines gültigen Spannungssignals und zum Ausgeben eines logischen Low- oder High-Signals.

Durch den Komparator werden diejenigen Spannungssignale "ausgefiltert", die in dem verbotenen Bereich liegen, dabei kann es auch vorgesehen sein, dass ein Fehlersignal ausgegeben wird, wenn das Spannungssignal in dem verbotenen Bereich liegt. Die gültigen Spannungssignale werden anschließend einem Bewertungsmittel zugeführt, das entweder ein logisches Low-Signal oder ein High-Signal ausgibt. Auf diese Weise können die konfigurierten Zustände zuverlässig unterschieden werden.

Vorzugsweise kann das Mittel zum Bewerten eines gültigen Spannungssignals einen Komparator umfassen, gegebenenfalls kann es sich dabei um den zuvor erwähnten Komparator oder Fensterkomparator handeln, der entscheidet, ob das Spannungssignal in einem gültigen oder einem "verbotenen Bereich liegt.

Ein besonders einfacher Aufbau ergibt sich, wenn das Mittel zum Bewerten eines gültigen Spannungssignals eine der folgenden logischen Operationen durchführt: "kleiner", "kleiner gleich", "größer" oder "größer gleich".

Es liegt auch im Rahmen der Erfindung, dass das als Subtrahierer oder Addierer ausgebildete Mittel das Spannungssignal derart verschiebt, dass der Wert 0 Volt im Wesentlichen in der Mitte zwischen den zu bewertenden Spannungsstufen liegt. Bei einer derartigen Verschiebung der Spannung liefern alle höheren Spannungen logisch "High", alle darunter liegenden Spannungen liefern logisch "Low". Dementsprechend erfolgt die Verschiebung in negativer Richtung.

Gemäß einer besonders bevorzugten Weiterbildung der Erfindung kann die Logikeinheit eine Schaltung zur Erzeugung einer Referenzspannung umfassen, die den Signalhub einer magnetischen Zelle, multipliziert mit einem für die Schaltung charakteristischen Strom angibt.

Erfindungsgemäß kann aus dieser Referenzspannung eine zweite, die Spannungsdifferenz zwischen zwei Stufen angebende Referenzspannung abgeleitet werden durch Multiplikation mit dem Verstärkungsfaktor des Differenzverstärkers, Halbieren und Teilen durch die Anzahl der Konfigurierzellen des Leitungszweigs. Diese Operationen können durch aktive oder passive Schaltungen realisiert werden.

Um die Auswertung weiter zu vereinfachen, kann es vorgesehen sein, dass die zweite Referenzspannung in drei vorzugsweise gleich große Spannungsbereiche teilbar ist, wobei der mittlere Spannungsbereich dem verbotenen Bereich und die beiden anderen Spannungsbereiche dem logischen Low- bzw. High-Signal entsprechen. Damit existiert ein mittlerer, verbotener Bereich, der "oben" und "unten" von gültigen Bereichen umgeben ist, wobei die Bereichsgrenzen durch Teilen der zweiten Referenzspannung in die drei Bereiche erhalten werden. Diese Grenzen für die Spannungen können mit vergleichsweise geringem Schaltungsaufwand erhalten werden.

Weitere logische Verknüpfungen lassen sich realisieren, wenn bei der erfindungsgemäßen Logikeinheit ein Logiksignal erzeugbar ist, falls die Differenzspannung innerhalb der verbotenen Zone liegt. Anstatt in diesem Fall ein Fehlersignal auszugeben, kann alternativ ein Logiksignal erzeugt werden. Dieses Logiksignal kann an einen Ausgang gegeben werden, der logisch high ist, wenn die Differenzspannung 0 ist. In Abhängigkeit der konfigurierten Zellen können auf diese Weise die folgenden logischen Verknüpfungen erzeugt werden: NOR, XOR, AND. Es ist auch möglich einen Inverter nachzuschalten, um eine der folgenden Logikfunktionen zu realisieren: XNOR, NAND, OR.

Weitere Vorteile und Einzelheiten der Erfindung werden anhand von Ausführungsbeispielen unter Bezugnahme auf die Figuren erläutert. Die Figuren sind schematische Darstellungen und zeigen:

Fig. 1      eine herkömmliche Logikeinheit mit zwei Datenzellen und zwei Konfigurationszellen;

Fig. 2      den Widerstand der Zellen in Abhängigkeit der mag- netischen Konfiguration;

Fig. 3      ein Diagramm des Spannungsverlaufs und des verbote- nen Bereichs;

Fig. 4      ein Diagramm einer erfindungsgemäßen Logikeinheit;

Fig. 5      eine Subtrahierschaltung der erfindungsgemäßen Lo- gikeinheit;

Fig. 6      ein Diagramm der Differenzspannungen bei verschie- denen Konfigurationen;

Fig. 7      eine Schaltung zur Erzeugung einer Referenzspan- nung;

Fig. 8      eine Schaltung zur Erzeugung weiterer Referenzspan- nungen;

Fig. 9      einen Fensterkomparator;

Fig. 10      ein Diagramm der Differenzspannungen, um Werte in dem "verbotenen" Bereich auszuwerten;

Fig. 11      eine schematische Darstellung der Schaltschwellen eines Fensterkomparators;

Fig. 12      einen Fensterkomparator;

Fig. 13      eine Schaltung zur Erzeugung einer Referenzspan- nung; und

Fig. 14      eine Schaltung zur Erzeugung symmetrischer Schwel- lenwerte für den verbotenen Bereich.

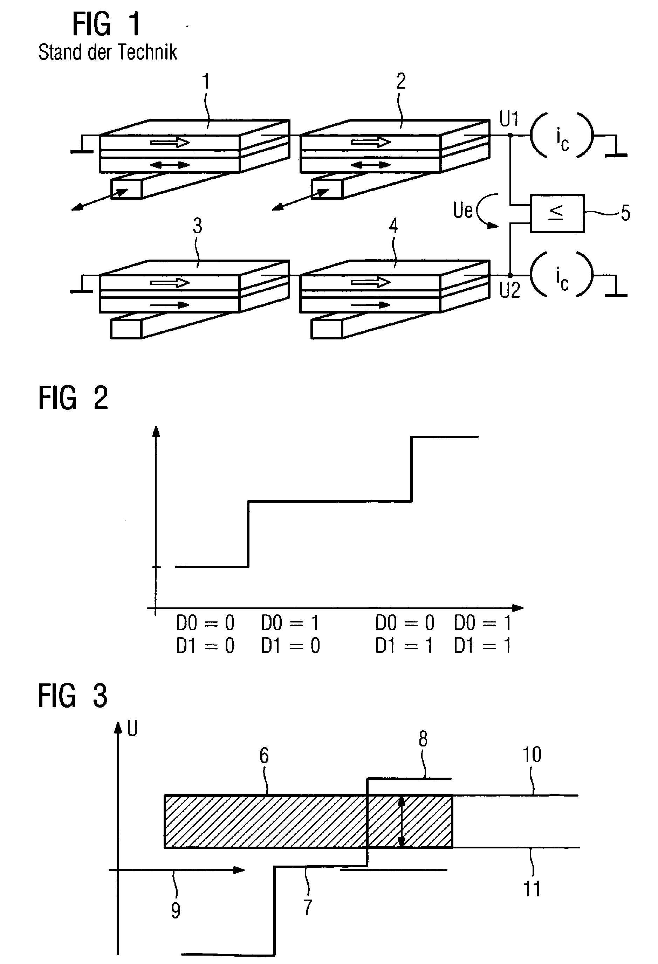

Fig. 1 zeigt eine herkömmliche Logikeinheit mit zwei Datenzellen und zwei Konfigurationszellen. Die Datenzellen 1, 2 und die Konfigurationszellen 3, 4 weisen jeweils ein magnetisches Schichtsystem auf. Durch eine quer zu den magnetischen Schichten verlaufende Leitung kann ein Magnetfeldpuls auf die Zellen ausgeübt werden, wodurch sich der Widerstand der Zellen ändert. Somit besitzt jede der Zellen entweder einen hohen oder einen niedrigen Widerstand entsprechend dem aufgebrachten Magnetfeldpuls.

Die Datenzellen 1, 2 und die Konfigurationszellen 3, 4 sind jeweils in Reihe geschaltet und an Konstantstromquellen angeschlossen, so dass in den Zweigen eine konstante Stromstärke $i_c$ fließt. Die von den Datenzellen 1, 2 bzw. den Konfigurationszellen 3, 4 gebildeten Zweige liefern Spannungssignale U1 bzw. U2 in Abhängigkeit der Spannungsabfälle beider Zweige, die zu den Eingängen eines Vergleichers 5 geführt werden.

Fig. 2 zeigt den Widerstand der Datenzellen in Abhängigkeit der magnetischen Konfiguration. Durch die magnetische Konfiguration der einzelnen Zellen 1, 2, die in Fig. 2 mit D0 und D1 bezeichnet werden und die entweder einen hohen oder einen niedrigen Widerstand besitzen können, ergibt sich ein stufenförmiger Verlauf des Gesamtwiderstands des Zweigs der in Reihe geschalteten Zellen. Wenn beide Zellen einen niedrigen Widerstand besitzen, ist der Widerstand am geringsten. Wenn die erste Datenzelle D0 oder die zweite Datenzelle D1 einen hohen Widerstand und die andere Datenzelle einen niedrigen Widerstand besitzt, ergibt sich ein mittlerer Widerstandswert, wenn beide Datenzellen D0, D1 einen hohen Widerstand aufweisen, ergibt sich die höchste Stufe des Gesamtwiderstands. In Fig. 2 ist das Verhalten für einen Zweig mit zwei Zellen dargestellt, wenn mehr als zwei Zellen in einem Zweig vorhanden sind, erhöht sich die Anzahl der Stufen entsprechend.

Mit dem in Fig. 1 dargestellten Vergleicher 5 soll die Differenzspannung in den beiden Zweigen ermittelt werden. Die relative Änderung des Widerstands einer Zelle beim magnetischen Schalten wird als XMR-Signalhub bezeichnet. Daraus ergibt sich die Spannungsdifferenz XMR · U durch das magnetische Schalten. Dabei wird vorausgesetzt, dass im Datenzweig und im Konfigurationszweig die gleiche Anzahl an Zellen vorhanden ist. Die Spannungsabfälle sollen bei den einzelnen Zellen jeweils übereinstimmen.

Die Höhe der Stufen kann bestimmt werden durch: $\Delta U = XMR/p \cdot U$, wobei p die Anzahl der in Reihe geschalteten Zellen ist. Die Spannung kann auch durch $i_c \cdot R_{min}$ ausgedrückt werden, sodass $\Delta U = XMR/p \cdot i_c \cdot R_{min}$ ist.

Durch den Vergleicher wird entschieden, ob die Differenzspannung U1-U2 der beiden Leitungszweige den untersten positiven Wert erreicht oder 0 ist, wobei auch der Fall kleiner als 0 eingeschlossen ist.

Wenn die Anzahl der hochohmigen Zellen größer als die Anzahl der niederohmigen Zellen ist, ist die Differenzspannung positiv, die logische Funktion "kleiner oder gleich" liefert das Ergebnis logisch 1. Wenn die Anzahl der hochohmigen Zellen gleich der Anzahl der niederohmigen Zellen ist, ist die Differenzspannung 0, der Ausgang liefert logisch 0. Wenn die Anzahl der hochohmigen Zellen kleiner als die Anzahl der niederohmigen Zellen ist, ist die Differenzspannung negativ, der Ausgang liefert logisch 0.

Für die Darstellung der magnetischen Zustände wird eine vereinfachte Schreibweise verwendet:

/ ein Widerstand ist maximal
\ ein Widerstand ist minimal

Da die Positionen der nominell identischen Widerstände innerhalb jedes Zweiges austauschbar sind (/\ entspricht \/), werden die Widerstände stets so sortiert dargestellt, dass auf der linken Seite die Zellen mit maximalem Widerstand (/) eingetragen werden.

Aus der nachfolgenden Tabelle ergeben sich die Zustände der Datenzellen und der Konfigurationszellen, die jeweilige Differenzspannung und das logische Ausgangssignal.

| Datenzellen | Konfigurationszellen | Differenzspannung | Ausgang | Funktion |
|---|---|---|---|---|
| \\ | \\ | null | logisch 0 | |
| /\ | \\ | positiv | logisch 1 | OR |
| // | \\ | positiv | logisch 1 | |
| | | | | |
| \\ | /\ | negativ | logisch 0 | |
| /\ | /\ | null | logisch 0 | AND |
| // | /\ | positiv | logisch 1 | |
| | | | | |
| \\ | // | negativ | logisch 0 | |
| /\ | // | negativ | logisch 0 | const |

(fortgesetzt)

| Datenzellen | Konfigurationszellen | Differenzspannung | Ausgang | Funktion |
|---|---|---|---|---|
| // | // | negativ | logisch 0 | |

Dieses logische Gatter kann zwischen den Funktionen OR bzw. AND konfiguriert werden. Die logische Verknüpfung AND kann konfiguriert werden, indem eine der Konfigurationszellen hochohmig und die andere niederohmig gewählt wird. Die Konfiguration mit zwei hochohmigen Konfigurationszellen erzeugt einen konstanten Ausgang. Bei den anderen Konfigurationen ist immer mindestens eine Konfigurationszelle im niederohmigen Zustand.

Damit zuverlässig entschieden werden kann, ob der konfigurierte Referenzzweig oder der Datenzweig einen höheren Widerstand hat, wird ein "verbotener" Bereich bzw. eine "verbotene" Zone definiert, wobei Spannungen oberhalb dieser Zone als logisch 1 und unterhalb dieser Zone als logisch 0 interpretiert werden. Würde man keine verbotene Zone definieren, wäre es bei bestimmten Parameterschwankungen nicht möglich, eine Entscheidung zwischen logisch 0 und logisch 1 zu treffen. Derartige Schwankungen der Zelleneigenschaften weisen auf Defekte hin, die Parameterschwankungen können unter anderem durch die Ungleichheit von Konstantstromquellen, Lithografieschwankungen, die Paarigkeit des XMR-Effekts, Zuleitungswiderstände oder eine asymmetrische Vergleicherschaltung verursacht werden.

Fig. 3 zeigt ein Diagramm der stufenförmigen Differenzspannungen sowie den verbotenen Bereich.

Auf der wagrechten Achse sind die drei verschiedenen Konfigurationen dargestellt, auf der senkrechten Achse ist die Spannung angegeben. Die eingezeichnete verbotene Zone 6 liegt zwischen den gewählten Stufen 7, 8. Für die logische Funktion "kleiner gleich" ist das nächstniedrige Niveau 0 Volt, das durch den Pfeil 9 angegeben wird. Das nächsthöhere Niveau besitzt den Wert $1 \cdot XMR/m \cdot U$. m ist dabei die Anzahl der in Reihe geschalteten Zellen, also wenigstens 2. Die verbotene Zone 6 wird durch die Obergrenze 10 und die Untergrenze 11 begrenzt.

Die verbotene Zone kann an herstellungsbedingte waferspezifische Parameterschwankungen des magnetischen oder des halbleitenden Teils angepasst werden. Durch die Einstellung der Höhe der verbotenen Zone kann eine Anpassung an den XMR-Effekt und den lokalen Parameterschwankungen erfolgen. Oberhalb und unterhalb der verbotenen Zone können Sicherheitszonen definiert werden, die Parameterschwankungen in einem gewissen Bereich zulassen. Als Referenzen für die verbotene Zone werden wenigstens zwei Angaben benötigt, nämlich die Höhe und die Position. Die verbotene Zone sollte den gleichen Temperaturgang wie der magnetische Teil des Logikgatters aufweisen. Die maximale Höhe der verbotenen Zone ergibt sich aus der Änderung des Widerstands einer XMR-Zelle.

Es ist möglich, ein Signal auszugeben, wenn die Ausgangsspannung in der verbotenen Zone liegt. Ein derartiges Signal kann auf ein Fehlverhalten der Logikeinheit hinweisen, beispielsweise auf einen Defekt.

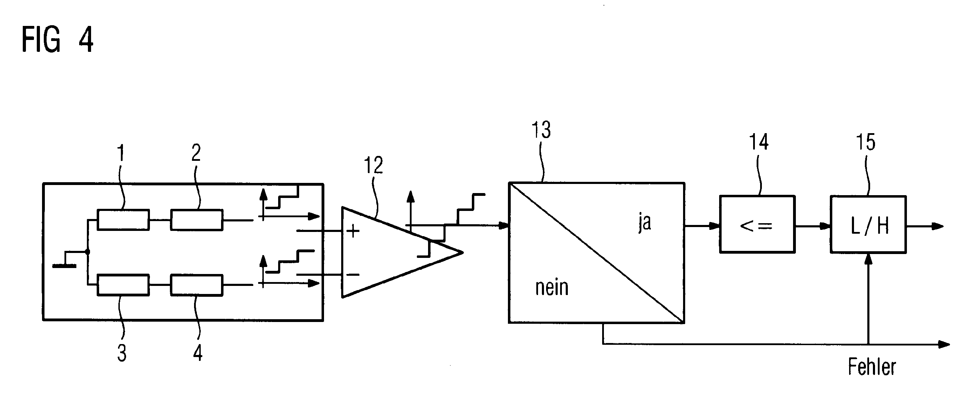

Fig. 4 zeigt ein schematisches Diagramm der erfindungsgemäßen Logikeinheit.

In dem dargestellten Ausführungsbeispiel werden Datenzellen 1, 2 und Konfigurationszellen 3, 4 verwendet, die jeweils in Reihe geschaltet sind. Die magnetischen Zellen geben einen Spannungswert aus, der in einem Differenzverstärker 12 zu einer Differenzspannung umgerechnet wird, die auf 0 Volt bezogen ist, es handelt sich also um ein Potential. Diese Differenzspannung kann um den Faktor K verstärkt oder abgeschwächt werden. Allerdings werden dabei Störungen wie Rauschen mitverstärkt, daher kann der Differenzverstärker 12 nicht für eine Bewertung des ausgegebenen Spannungssignals genutzt werden.

Anschließend wird in dem Schritt 13 geprüft, ob die von dem Differenzverstärker gelieferte Differenzspannung gültig ist oder ob sie innerhalb der verbotenen Zone liegt. Der Schritt 13 ist erforderlich, um fehlerhafte Bewertungen zu verhindern, die beispielsweise durch Bauteiledefekte oder durch herstellungsbedingte Parameterschwankungen verursacht werden können. Dazu wird die Gültigkeit der Differenzspannung im Hinblick auf eine Verletzung der verbotenen Zone überprüft, wobei als Entscheidungskriterium die logische Funktion "kleiner gleich" verwendet wird. Wenn die verbotene Zone nicht verletzt ist, liegt kein Fehler vor und das Ausgangssignal ist gültig. Andererseits, wenn der Spannungspegel innerhalb der verbotenen Zone liegt, kann ein Fehlersignal ausgegeben werden. Das gültige Signal wird in einem Komparator 14 bewertet und als "0" oder "1" an den Ausgang 15 gegeben. Falls im Schritt 13 festgestellt wurde, dass der Spannungspegel ungültig ist, wird ein Fehlersignal ausgegeben.

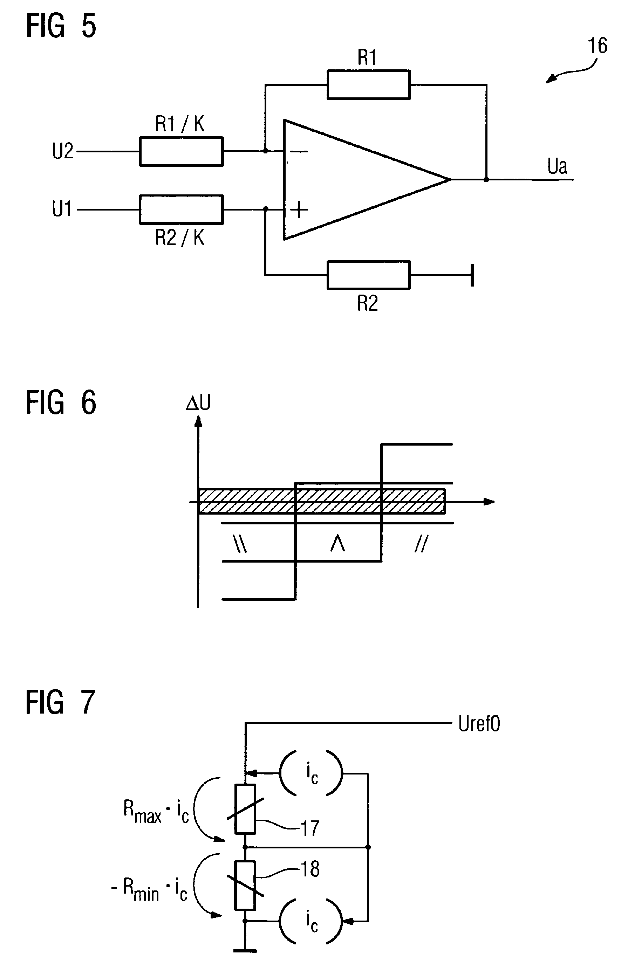

Fig. 5 zeigt eine Subtrahierschaltung der erfindungsgemäßen Logikeinheit. Die Differenzspannung wird mit einer Differenzverstärkerstufe 16 mit der Verstärkung K gebildet. Die Eingangsspannungen U1 und U2 werden von den beiden Leitungszweigen der Daten- und Konfigurierzellen geliefert. Durch die Differenzverstärkerstufe 16 wird die Ausgangsspannung $Ua = K \cdot (U1-U2)$ ausgegeben.

Anschließend wird das Ergebnis im Spannungsbereich so verschoben, dass keine Stufe bei 0 Volt liegt.

Fig. 6 zeigt die Differenzspannungen der verschiedenen Konfigurationen sowie die verbotene Zone. In diesem Fall liegt das 0 Volt-Niveau zentrisch zwischen zwei Stufen, und zwar zwischen denjenigen Stufen, an denen die Bewertung stattfinden soll. Spannungen oberhalb der verbotenen Zone liefern ein logisches High-Signal, Spannungen unterhalb der verbotenen Zone ein logisches Low-Signal. Dementsprechend muss die Verschiebung in negativer Richtung, das heißt in dem Diagramm von Fig. 6 nach unten um die Referenzspannung $Uref1 = XMR/p \cdot U/2$ erfolgen.

Bei anderen Ausführungen kann diese Stufe auch mit der in Fig. 5 dargestellten Differenzverstärkerstufe 16 kombiniert sein.

Fig. 7 zeigt eine Schaltung zur Erzeugung einer Referenzspannung.

Die in Fig. 7 dargestellte Schaltung besteht aus magnetischen Zellen, nämlich einer hochohmigen Zelle 17 und einer niederohmigen Zelle 18, an denen die Spannungen $R_{max} \cdot i_c$ bzw. $-R_{min} \cdot ic$ abfallen. Durch diese Schaltung wird der TMR-Signalhub mal dem für die Schaltung charakteristischen Strom $i_c$ als Ausgangsspannung geliefert. Auf diese Weise ergibt sich die Referenzspannung Uref0. Für die Erzeugung der Referenzspannung Uref1 ist die Multiplikation mit K, die Halbierung und Division durch p erforderlich. p gibt die Anzahl der in Reihe geschalteten Zellen an. Für die Erzeugung der Referenzspannung Uref1 können aktive oder passive Schaltungen eingesetzt werden.

In diesem Ausführungsbeispiel werden die Grenzen der verbotenen Zone festgelegt, indem eine Stufe in drei Teile geteilt wird. Der mittlere Bereich dieser Stufe bildet die verbotene Zone, die darunter und darüber liegenden Bereiche werden der unteren bzw. oberen Stufe als logische Werte zugeordnet. Die Teilung der Stufen in drei Bereiche bedeutet, dass im Anschluss an die Verschiebung die Referenzspannungen

$$Uref2 = +K \cdot XMR/p \cdot U/6$$

$$Uref3 = -K \cdot XMR/p \cdot U/6$$

erzeugt werden müssen. Diese Referenzspannungen können durch die gewählte Verschiebung durch Invertierung gewonnen werden. Die als Basisreferenz dienende Referenzspannung wird wie in Fig. 7 gezeigt gewonnen, diese Referenzspannung wird gemäß der folgenden Formel abgeschwächt oder verstärkt:

$$Uref0 = K/p \cdot Uref$$

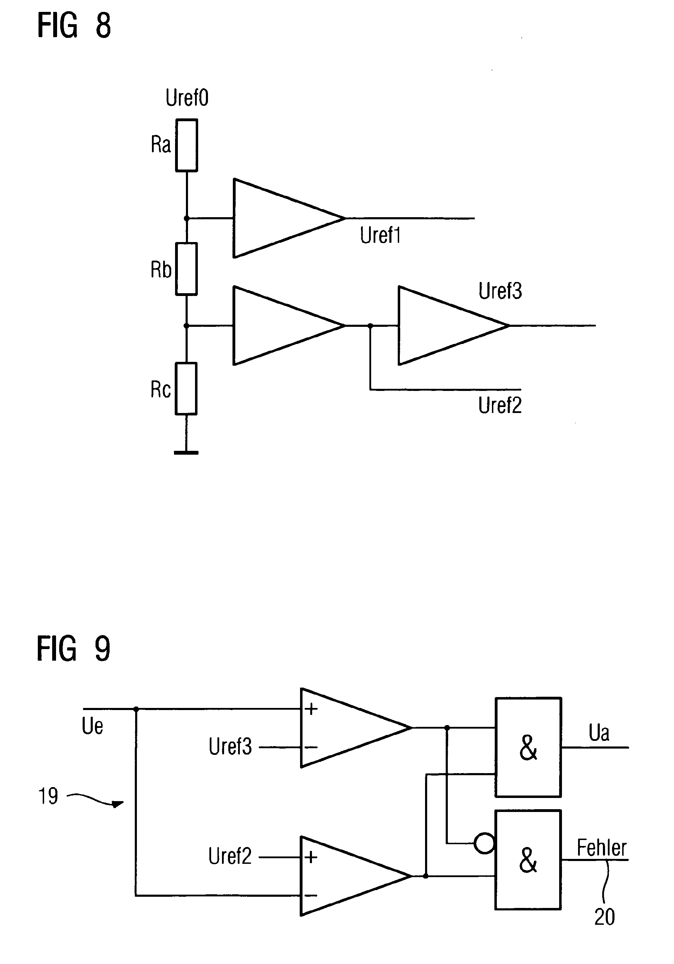

Fig. 8 zeigt eine Schaltung zur Erzeugung der benötigten Referenzspannungen. Das Verhältnis der Widerstände wird wie folgt festgelegt:

$$Ra:Rb:Rc = 3:2:1$$

Die Referenzspannung Uref2 wird anschließend invertiert. Die auf diese Weise erzeugten Referenzspannungen können von mehreren Logikeinheiten einer integrierten Schaltung genutzt werden.

Fig. 9 zeigt einen Fensterkomparator 19, der entscheidet, ob die verbotene Zone verletzt wurde. Falls die Spannung innerhalb des verbotenen Bereichs liegt, wird ein Fehlersignal über eine Ausgangsleitung 20 ausgegeben. Andernfalls, wenn die Spannung nicht innerhalb der verbotenen Zone liegt, wird die Spannung Ua ausgegeben.

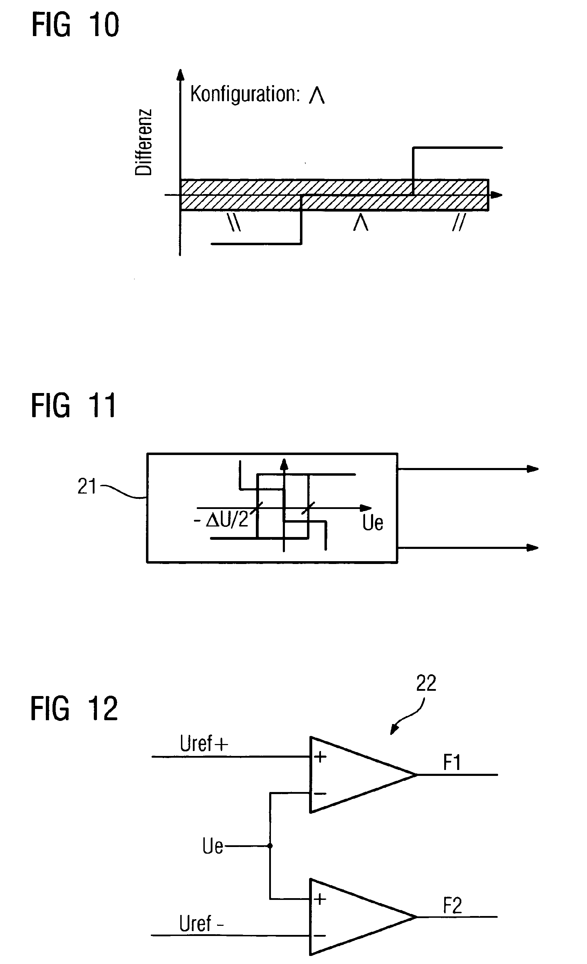

Fig. 10 zeigt ein Diagramm der Differenzspannungen eines zweiten Ausführungsbeispiels der Erfindung, bei dem auch in den verbotenen Bereich fallende Werte ausgewertet werden. Durch diese zusätzliche Information wird der Designraum der magnetischen Logik erheblich erweitert, insbesondere können weitere logische Verknüpfungen realisiert werden. Um Verwechslungen zu vermeiden, wird die "verbotene Zone" bei dem zweiten Ausführungsbeispiel in "mittlere Zone" umbenannt. In der nachfolgenden Tabelle sind die Zustände der Daten- und Konfigurationszellen, die Differenzspannung, sowie die Ausgänge 1 und 2 aufgeführt. Die Spalte "Ausgang 1" entspricht den Ausgangssignalen der Logikeinheit des ersten Ausführungsbeispiels. In einem weiteren Schritt werden die Werte von "Ausgang 2" als logische Funktion der Eingänge gebildet.

| Datenzellen | Konfigurationszellen | Differenzspannung | Ausgang 1 | Ausgang 2 | Funktion |
|---|---|---|---|---|---|
| \\ | \\ | null | logisch 0 | logisch 1 | |
| ∧ | \\ | positiv | logisch 1 | logisch 0 | NOR |
| // | \\ | positiv | logisch 1 | logisch 0 | |

(fortgesetzt)

| Datenzellen | Konfigurationszellen | Differenzspannung | Ausgang 1 | Ausgang 2 | Funktion |
|---|---|---|---|---|---|
| | | | | | |
| \\ | /\ | negativ | logisch 0 | logisch 0 | |
| /\ | /\ | null | logisch 0 | logisch 1 | XOR |
| // | /\ | positiv | logisch 1 | logisch 0 | |
| | | | | | |
| \\ | // | negativ | logisch 0 | logisch 0 | |
| /\ | // | negativ | logisch 0 | logisch 0 | AND |
| // | // | null | logisch 0 | logisch 1 | |

"Ausgang 1" entspricht den logischen Verknüpfungen OR, AND und const. "Ausgang 2" wird logisch "1", wenn die Differenzspannung in die mittlere Zone fällt. Auf diese Weise ergeben sich die logischen Verknüpfungen NOR, XOR sowie AND. Mit einem nachgeschalteten Inverter können die Verknüpfungen XNOR, NAND sowie OR erzeugt werden.

Fig. 11 ist eine schematische Darstellung der Schaltschwellen eines Fensterkomparators. Die Entscheidung, ob die Differenzspannung unterhalb, oberhalb oder innerhalb der mittleren Zone liegt, wird mit dem Fensterkomparator 21 durchgeführt. Die mittlere Zone liegt zentrisch um die mittlere Stufe, die sich in der Nähe der 0 Volt-Linie befindet. Die Breite der mittleren Zone ist so eingestellt werden, dass sie näherungsweise einer Stufenhöhe ΔU entspricht.

Der Fensterkomparator 21 schaltet, wenn die Eingangsspannung den oberen Schwellwert, der in diesem Fall ΔU/2 beträgt, überschreitet. Der Fensterkomparator 21 schaltet erneut, wenn die Eingangsspannung den unteren Schwellenwert, der in diesem Fall - ΔU/2 beträgt, unterschreitet.

Zur Erzeugung der Schwellenwerte, die die mittlere Stufe begrenzen, müssen die Spannungen $\Delta U = \pm$ XMR/p·U/2 erzeugt werden, wobei die Spannungssymmetrie zu 0 Volt vorteilhaft genutzt wird.

Fig. 12 zeigt einen Fensterkomparator 22, dem zwei Referenzspannungen Uref+ und Uref- zugeführt werden. Auf den Eingang des Fensterkomparators 22 wird die gemäß Fig. 11 gewonnene Spannung Ue gegeben, an den Ausgängen des Fensterkomparators 22 werden die Zwischenergebnisse F1 und F2 ausgegeben. Diese Signale können als logische Signale entweder in magnetischer Logik oder in Silizium weiterverarbeitet werden.

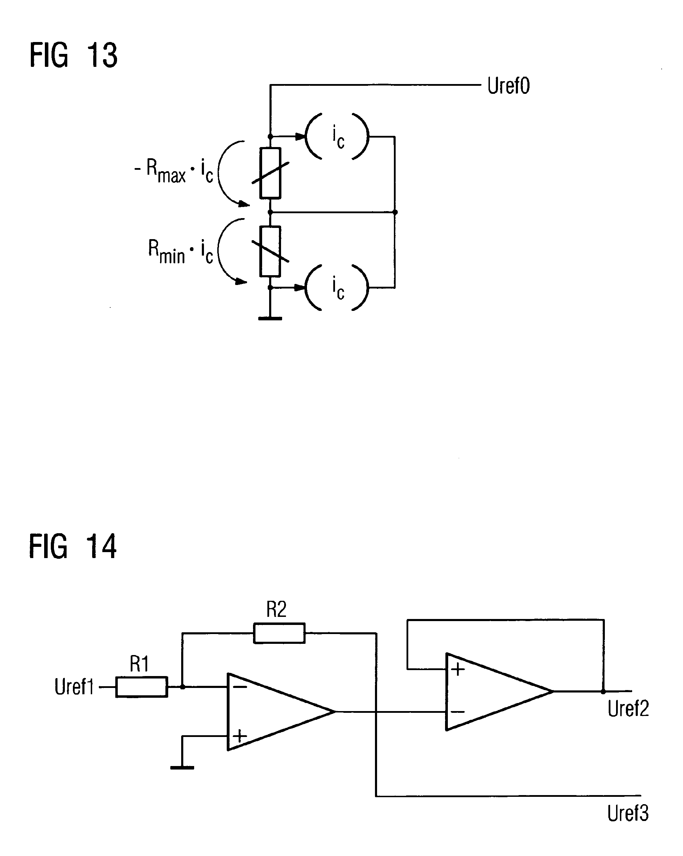

Fig. 13 zeigt eine Schaltung zur Erzeugung einer Referenzspannung. Der prinzipielle Aufbau entspricht demjenigen der Schaltung von Fig. 7. In einem ersten Schritt wird die Stufenhöhe als Referenzspannung $Uref1 = i_c \cdot XMR \cdot R_{min}$ erzeugt. Dazu wird die Differenz der beiden Spannungsabfälle an der hochohmigen und der niederohmigen Zelle entsprechend auf 0 bezogen. Durch die Nutzung eines invertierenden Verstärkers ergibt sich: Uref0 = -Uref1. In einem zweiten Schritt wird diese Referenzspannung auf die Hälfte der tatsächlich benötigten Stufenhöhe ΔU gebracht. Dieses kann entweder passiv durch einen Spannungsteiler oder aktiv durch einen Operationsverstärker erfolgen. In einem dritten Schritt wird diese Spannung auch als invertierte Spannung erzeugt.

Fig. 14 zeigt eine Schaltung zur Erzeugung symmetrischer Schwellenwerte für den verbotenen Bereich. Dabei gilt Uref3 = -Uref1·R2/R1 und Uref2 = -Uref3.

Wenn beispielsweise vier TMR-Zellen in einem Zweig vorhanden sind, deren Widerstände etwa zwischen 0,1 Ohm und 1 MOhm liegen, kann die in Fig. 14 dargestellte Schaltung bei nicht verstärkter Differenzspannung, das heißt K=1, die folgenden Widerstände besitzen: R1 = 800 kOhm, R2 = R1/p/2 = 100 kOhm.

Wenn die Stufen durch eine Verstärkung der Differenzspannung "gedehnt" werden, kann eine geringere Abschwächung gewählt werden, bei einer Verstärkung von K=4 ergibt sich: R1=800 kOhm, R2=R1/p/2·4 = 400 kOhm. Uref2 wird mit Uref+ verbunden und Uref3 mit Uref-.

Das Verhalten der Zwischenergebnisse F1 und F2 kann wie folgt beschrieben werden: F1 wechselt von positiver Betriebsspannung auf die negative Betriebsspannung, wenn

$$Ue \cdot K > Uref2 = i_c \cdot XMR \cdot R_{min}/p/2 \cdot K$$

wird. F1 wechselt wieder zurück, sobald es kleiner ist. F2 wechselt von negativer Betriebsspannung auf die positive Betriebsspannung, wenn

$$Ue \cdot K > Uref3 = -i_c \cdot XMR \cdot R_{min}/p/2 \cdot K$$

ist. F2 wechselt zurück, sobald es kleiner ist.

Die Werte der Zwischenergebnisse F1 und F2 in Abhängigkeit der Daten- und Konfigurationszellen ergeben sich aus der nachfolgenden Tabelle.

| Datenzellen | Konfigurationszellen | Differenzspannung | F1 | F2 |
|---|---|---|---|---|
| \\ | \\ | null | logisch 1 | logisch 1 |
| ∧ | \\ | positiv | logisch 0 | logisch 1 |
| // | \\ | positiv | logisch 0 | logisch 1 |
| | | | | |
| \\ | ∧ | negativ | logisch 1 | logisch 0 |
| ∧ | ∧ | null | logisch 1 | logisch 1 |
| // | ∧ | positiv | logisch 0 | logisch 1 |
| | | | | |
| \\ | // | negativ | logisch 1 | logisch 0 |
| ∧ | // | negativ | logisch 1 | logisch 0 |
| // | // | null | logisch 1 | logisch 1 |

Für die Eingänge der Datenzellen, die hier mit D1 und D0 bezeichnet werden, ergeben sich die folgenden logischen Verknüpfungen:

| Ausgang | \\ | ∧ | // |
|---|---|---|---|
| F1 | NOR | NAND | const=1 |
| F2 | const=1 | OR | AND |

Durch Invertieren der Ausgänge ergeben sich die folgenden Funktionen für die Eingänge D1 und D0:

| Ausgang | \\ | ∧ | // |
|---|---|---|---|
| NOT(F1) | OR | AND | const=0 |
| NOT(F2) | const=0 | NOR | NAND |

Daraus lassen sich die folgenden Gatterverknüpfungen bilden:

| Verknüpfung | \\ | ∧ | // |
|---|---|---|---|
| OR(F1;F2) | const=1 | const=1 | const=1 |
| NOR(F1;F2) | const=0 | const=0 | const=0 |
| AND(F1;F2) | NOR | XOR | AND |
| NAND(F1;F2) | OR | XNOR | NAND |

Wenn diese Gatterverknüpfungen invertiert werden, ergibt sich:

| Verknüpfung | \\ | /\ | // |
|---|---|---|---|
| OR(NOT(F1);NOT(F2)) | OR | XNOR | NAND |
| NOR(NOT(F1);NOT(F2)) | NOR | XOR | AND |
| AND(NOT(F1);NOT(F2)) | const=0 | const=0 | const=0 |
| NAND(NOT(F1);NOT(F2)) | const=1 | const=1 | const=1 |

**Patentansprüche**

1. Nichtflüchtig rekonfigurierbare digitale Logikeinheit mit ein magnetisches Schichtsystem aufweisenden Zellen, deren Widerstand durch Magnetfeldpulse veränderbar ist, umfassend einen ersten Leitungszweig mit in Reihe geschalteten Datenzellen und einen zweiten Leitungszweig mit in Reihe geschalteten konfigurierbaren Konfigurierzellen und ein Auswertemittel für die konfigurierten Zustände, **dadurch gekennzeichnet, dass** das Auswertemittel umfasst:

   - einen Differenzverstärker (12) zum Ermitteln eines die Differenzspannung der Leitungszweige angebenden Spannungssignals;
   - ein vorzugsweise als Addierer oder Subtrahierer ausgebildetes Mittel zum Verschieben des Spannungssignals auf einen von 0 Volt verschiedenen Wert;
   - einen Komparator (14) oder Fensterkomparator (19, 21), um zu entscheiden, ob das Spannungssignal in einem gültigen oder in einem verbotenen Bereich liegt;
   - ein Mittel zum Bewerten eines gültigen Spannungssignals und zum Ausgeben eines logischen Low- oder High-Signals.

2. Logikeinheit nach Anspruch 1, **dadurch gekennzeichnet, dass** bei einem innerhalb des verbotenen Bereichs liegenden Spannungssignal ein Fehlersignal ausgebbar ist.

3. Logikeinheit nach Anspruch 1 oder 2, **dadurch gekennzeichnet, dass** das Mittel zum Bewerten eines gültigen Spannungssignals einen Komparator umfasst.

4. Logikeinheit nach Anspruch 1 oder 2, **dadurch gekennzeichnet, dass** der Komparator (14) oder Fensterkomparator (19, 21) als Mittel zum Bewerten eines gültigen Spannungssignals einsetzbar ist.

5. Logikeinheit nach einem der vorangehenden Ansprüche, **dadurch gekennzeichnet, dass** das Mittel zum Bewerten eines gültigen Spannungssignals auf einer der logischen Operationen "kleiner", "kleiner gleich", "größer" oder "größer gleich" basiert.

6. Logikeinheit nach einem der vorangehenden Ansprüche, **dadurch gekennzeichnet, dass** das als Addierer oder Subtrahierer ausgebildete Mittel das Spannungssignal derart verschiebt, dass 0 Volt im Wesentlichen in der Mitte zwischen den zu bewertenden Spannungsstufen liegt.

7. Logikeinheit nach einem der vorangehenden Ansprüche, **dadurch gekennzeichnet, dass** sie eine Schaltung zur Erzeugung einer Referenzspannung umfasst, die den Signalhub einer magnetischen Zelle (17, 18), multipliziert mit einem für die Schaltung charakteristischen Strom angibt.

8. Logikeinheit nach Anspruch 7, **dadurch gekennzeichnet, dass** aus der Referenzspannung eine zweite, die Spannungsdifferenz zwischen zwei Stufen angebende Referenzspannung durch Multiplikation mit dem Verstärkungsfaktor des Differenzverstärkers, Halbieren und Teilen durch die Anzahl der Konfigurierzellen (3, 4) des Leitungszweigs ableitbar ist.

9. Logikeinheit nach Anspruch 8, **dadurch gekennzeichnet, dass** die zweite Referenzspannung in drei vorzugsweise gleich große Spannungsbereiche teilbar ist, wobei der mittlere Spannungsbereich dem verbotenen Bereich und die beiden anderen Spannungsbereiche dem logischen Low- bzw. High-Signal entsprechen.

10. Logikeinheit nach einem der vorangehenden Ansprüche, **dadurch gekennzeichnet, dass** ein Logiksignal erzeugbar ist, wenn die Differenzspannung innerhalb der verbotenen Zone liegt.

**11.** Logikeinheit nach Anspruch 10, **dadurch gekennzeichnet, dass** in Abhängigkeit der Einstellung der Konfigurationszellen (3, 4) eine der folgenden Logikfunktionen wählbar ist: NOR, XOR, AND.

**12.** Logikeinheit nach Anspruch 11, **dadurch gekennzeichnet, dass** ein nachgeschalteter Inverter vorgesehen ist, um eine der folgenden Logikfunktionen zu realisieren: XNOR, NAND, OR.


**Claims**

**1.** Digital logic unit which can be reconfigured in nonvolatile form having cells which have a magnetic layer system and whose resistance can be altered by magnetic field pulses, comprising a first line path containing series-connected data cells and a second line path containing series-connected configurable configuration cells and an evaluation means for the configured states, **characterized in that** the evaluation means comprises:

- a differential amplifier (12) for ascertaining a voltage signal indicating the difference voltage for the line paths;
- a means which is preferably in the form of an adder or subtractor for shifting the voltage signal to a value which is different than 0 volt;
- a comparator (14) or window comparator (19, 21) for deciding whether the voltage signal is in a valid range or in a prohibited range;
- a means for rating a valid voltage signal and for outputting a logic Low or High signal.

**2.** Logic unit according to Claim 1, **characterized in that** an error signal can be output for a voltage signal which is within the prohibited range.

**3.** Logic unit according to Claim 1 or 2, **characterized in that** the means for rating a valid voltage signal comprises a comparator.

**4.** Logic unit according to Claim 1 or 2, **characterized in that** the comparator (14) or window comparator (19, 21) can be used as a means for rating a valid voltage signal.

**5.** Logic unit according to one of the preceding claims, **characterized in that** the means for rating a valid voltage signal is based on one of the logic operations "less than", "less than or equal to", "greater than" or "greater than or equal to".

**6.** Logic unit according to one of the preceding claims, **characterized in that** the means in the form of an adder or subtractor shifts the voltage signal such that 0 volt is essentially in the center between the voltage levels which are to be rated.

**7.** Logic unit according to one of the preceding claims, **characterized in that** it comprises a circuit for producing a reference voltage which indicates the signal swing for a magnetic cell, (17, 18), multiplied by a current which is characteristic of the circuit.

**8.** Logic unit according to Claim 7, **characterized in that** the reference voltage can be used to derive a second reference voltage, indicating the voltage difference between two levels, by virtue of multiplication by the gain factor of the differential amplifier, halving and division by the number of configuration cells (3, 4) in the line path.

**9.** Logic unit according to Claim 8, **characterized in that** the second reference voltage can be divided into three voltage ranges which are preferably of equal magnitude, where the middle voltage range corresponds to the prohibited range and the other two voltage ranges correspond to the logic Low or High signal.

**10.** Logic unit according to one of the preceding claims, **characterized in that** a logic signal can be produced when the difference voltage is within the prohibited zone.

**11.** Logic unit according to Claim 10, **characterized in that** the setting of the configuration cells (3, 4) can be taken as a basis for selecting one of the following logic functions: NOR, XOR, AND.

**12.** Logic unit according to Claim 11, **characterized in that** a downstream inverter is provided in order to implement one of the following logic functions: XNOR, NAND, OR.

**Revendications**

1. unité logique numérique, non volatile, à reconfiguration, comprenant des cellules ayant un système de couche magnétique dont la résistance peut être modifiée par des impulsions de champ magnétique, comprenant une première branche de ligne ayant des cellules de données montées en série et une deuxième branche de ligne ayant des cellules de configuration configurables montées en série et un moyen d'exploitation des états configurés, **caractérisée en ce que** moyen d'exploitation comprend :

   - un amplificateur (12) différentiel pour déterminer un signal de tension indiquant la tension différentielle entre les branches de ligne ;
   - un moyen, constitué de préférence en additionneur ou en soustracteur, pour décaler le signal de tension à une valeur différente de 0 volt;
   - un comparateur (14) ou un comparateur (19, 21) à fenêtre pour décider si le signal de tension se trouve dans une plage valable ou dans une plage interdite ;
   - un moyen d'évaluation d'un signal de tension valable et d'émission d'un signal logique haut/bas.

2. Unité logique suivant la revendication 1,
   **caractérisée en ce que**, pour un signal de tension se trouvant dans une plage interdite, un signal d'erreur peut être émis.

3. Unité logique suivant la revendication 1 ou 2,
   **caractérisée en ce que** le moyen d'évaluation d'un signal de tension valable comprend un comparateur.

4. Unité logique suivant la revendication 1 ou 2,
   **caractérisé en ce que** le comparateur (14) ou le comparateur (19, 21) à fenêtre peut être utilisé en tant que moyen d'évaluation d'un signal de tension valable.

5. Unité logique suivant l'une des revendications précédentes,
   **caractérisée en ce que** le moyen d'évaluation d'un signal de tension valable repose sur l'une des opérations logiques « inférieur à » « inférieur ou égal à » « supérieur à » ou « supérieur ou égal à ».

6. Unité logique suivant l'une des revendications précédentes,
   **caractérisée en ce que** le moyen constitué sous la forme d'un additionneur ou d'un soustracteur décale le signal de tension de façon à ce que 0 volt se trouve sensiblement au milieu entre les paliers de tension à évaluer.

7. Unité logique suivant l'une des revendications précédentes,
   **caractérisée en ce qu'**elle comprend un circuit de production d'une tension de référence, qui indique la déviation du signal d'une cellule (17, 18) magnétique multipliée par un courant caractéristique du circuit.

8. Unité logique suivant la revendication 7,
   **caractérisée en ce que** l'on peut déduire de la tension de référence une deuxième tension de référence indiquant la différence de tension entre deux paliers, par multiplication par le facteur d'amplification de l'amplificateur différentielle division par deux et division par le nombre des cellules (3, 4) de configuration de la branche de ligne.

9. Unité logique suivant la revendication 8,
   **caractérisée en ce que** la deuxième tension de référence peut être divisée en trois plages de tension, de préférence de même dimension, la plage moyenne de tension correspondant à la plage interdite et les deux autres plages de tension au signal logique bas et haut.

10. Unité logique suivant l'une des revendications précédentes,
    **caractérisée en ce qu'**un signal logique peut être produit lorsque la différence de tension est dans la zone interdite.

11. Unité logique suivant la revendication 10,
    **caractérisée en ce que**, en fonction du réglage des cellules de (3, 4) de configuration, on peut choisir l'une des fonctions logiques suivantes : non ou, ou exclusif, et.

12. Unité logique suivant la revendication 11,
    **caractérisée en ce qu'**il est prévu un inverseur en aval pour réaliser l'une des fonctions logiques suivantes : non ou exclusif, non et, ou.

## FIG 1
Stand der Technik

## FIG 2

| D0 = 0 | D0 = 1 | D0 = 0 | D0 = 1 |
| D1 = 0 | D1 = 0 | D1 = 1 | D1 = 1 |

## FIG 3

# FIG 4

EP 1 836 770 B1

| 1 | 2 | 12 | 13 | 14 | 15 |

+

−

ja

nein

<=

L / H

Fehler

## FIG 5

## FIG 6

## FIG 7

# FIG 8

Uref0

Ra

Rb

Rc

Uref1

Uref3

Uref2

# FIG 9

Ue

Uref3

Uref2

19

&

&

Ua

Fehler

20

## FIG 10

Konfiguration: ∧

Differenz

\\ ∧ //

## FIG 11

21

- ΔU/2    Ue

## FIG 12

22

Uref +    +

Ue    F1

−

+    F2

Uref −    −

## FIG 13

UrefO

$-R_{max} \cdot i_c$

$i_c$

$R_{min} \cdot i_c$

$i_c$

## FIG 14

R2

R1

Uref1

Uref2

Uref3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

*   **BLACK ; DAS.** Programmable logic using giant-magnetoresistance and spin-dependent tunneling devices. *Journal of Applied Physics,* 2000, vol. 87 (9